# FASCICULE DE BREVET EUROPEEN

(11) **EP 4 055 395 B1**
(45) Date de publication et mention de la délivrance du brevet: **03.01.2024**
(21) Numéro de dépôt: 20800152.9
(22) Date de dépôt: 04.11.2020
(51) Int. Cl.: G01R 15/20

(54) **DÉTECTEUR DE COURANT, CAPTEUR, SYSTÈME ET PROCÉDÉ ASSOCIÉS**
STROMDETEKTOR, ZUGEHÖRIGER SENSOR, SYSTEM UND VERFAHREN
CURRENT DETECTOR, ASSOCIATED SENSOR, SYSTEM AND METHOD

(30) Priorité: 05.11.2019 FR 1912406
(43) Date de publication de la demande: 14.09.2022
(73) Titulaire: Centre national de la recherche scientifique, 75016 Paris (FR); Ecole Normale Supérieure Paris-Saclay, 91190 Gif-sur-Yvette (FR)
(72) Inventeur: LOYAU, Vincent, 75011 PARIS (FR); CHAPLIER, Gérard, 91940 les Ulis (FR); MAZALEYRAT, Frédéric, 91400 ORSAY (FR)
(74) Mandataire: Hautier IP
(86) Numéro de dépôt international: PCT/EP2020/080984
(87) Numéro de publication internationale: WO 2021/089634

(56) Documents cités:
- CN-A- 106 908 634
- CN-A- 109 425 774
- CN-A- 109 425 775
- ZHANG JITAO ET AL: "Broadband high-sensitivity current-sensing device utilizing nonlinear magnetoelectric medium and nanocrystalline flux concentrator", REVIEW OF SCIENTIFIC INSTRUMENTS, AMERICAN INSTITUTE OF PHYSICS, 2 HUNTINGTON QUADRANGLE, MELVILLE, NY 11747, vol. 86, no. 9, 1 September 2015 (2015-09-01), XP012200416, ISSN: 0034-6748, DOI: 10.1063/1.4930150 [retrieved on 1901-01-01]
- KOGA F ET AL: "A New Type of Current Sensor Based on Inverse Magnetostriction for Large Current Detection", IEEE TRANSACTIONS ON MAGNETICS, IEEE, USA, vol. 45, no. 10, 1 October 2009 (2009-10-01), pages 4506-4509, XP011277183, ISSN: 0018-9464, DOI: 10.1109/TMAG.2009.2022187

## Description

La présente invention concerne un détecteur de courant propre à mesurer un courant circulant dans un conducteur électrique. La présente invention concerne également un système et un procédé de détection associés.

Pour de nombreuses applications impliquant des moteurs électriques, il est souhaitable de connaître avec précision le courant électrique instantané circulant dans un conducteur. C'est également le cas pour d'autres applications telles que, par exemple, la gestion de l'énergie stockée dans des batteries ou les compteurs électriques pour le secteur ou les circuits connectés à de tels dispositifs.

Pour cela, il est connu d'utiliser des sondes à effet Hall qui détectent le champ magnétique produit par le courant électrique à mesurer circulant dans un câble. L'effet Hall est la propriété générale des conducteurs et semi-conducteurs électriques qui produisent une tension électrique lorsqu'ils sont plongés dans un champ magnétique en étant parcourus par un courant de polarisation.

Toutefois, de telles sondes présentent une dérive en tension qui peut résulter dans certains cas dans l'utilisation simultanée de plusieurs sondes à effet Hall, connectées à un circuit électronique complexe.

Selon une autre technique, une résistance est insérée dans le circuit. La résistance sert alors de « shunt » et permet la mesure du courant électrique par le relevé de la tension à ses bornes due à la loi d'Ohm.

Néanmoins, les inconvénients d'une telle technique sont l'insertion d'un composant dissipatif dans le circuit et l'absence d'isolation galvanique entre le circuit à mesurer et le circuit de mesure.

Une autre technique connue consiste à utiliser un transformateur de courant comportant un primaire en série dans le circuit et un secondaire offrant une tension électrique proportionnelle au courant variable présent dans le primaire.

Mais avec l'emploi d'un tel transformateur, il n'est pas possible de mesurer des courants continus. Le principe oblige également à couper le circuit pour y insérer un élément réactif qui peut éventuellement en perturber le fonctionnement. Pour mesurer des fréquences basses ou des courants très intenses, un circuit magnétique de forte taille est prévu ce qui rend un tel capteur de courant lourd et cher.

Encore une autre technique est illustrée par les documents CN 106 908 364 A, CN 109 425 775 A et CN 109 425 774 A qui proposent chacun de déterminer un courant à l'aide d'un effet magnétostrictif dans un capteur passif.

Toutefois, de tels capteurs passifs ne permettent pas non plus de mesurer des courants continus, uniquement des courants alternatifs. D'autre part, les publications suivantes divulguent aussi des capteurs de courant:

HANG JITAO ET AL: "Broadband high-sensitivity current-sensing device utilizing nonlinear magnetoelectric medium and nanocrystalline flux concentrator", REVIEW OF SCIENTIFIC INSTRUMENTS, AMERICAN INSTITUTE OF PHYSICS, 2 HUNTINGTON QUADRANGLE, MELVILLE, NY 11747, vol. 86, no. 9, 1 septembre 2015, XP012200416, ISSN: 0034-6748, DOI: 10.1063/1 .493015

KOGA F ET AL: "A New Type of Current Sensor Based on Inverse Magnétostriction for Large Current Détection", IEEE TRANSACTIONS ON MAGNETICS, IEEE, USA, vol. 45, no. 10, 1 octobre 2009, pages 4506-4509, XP011277183, ISSN: 0018-9464, DOI: 10.1109/ TMAG.2009.2022187

Il existe donc un besoin pour un détecteur de courant plus simple permettant de mesurer un courant électrique avec une précision de mesure satisfaisante et stable dans le temps.

A cet effet, il est décrit un détecteur de courant dans la revendication 1.

Ainsi, le détecteur de courant est un capteur actif capable de mesurer tout type de courant (alternatif / continu / continu et alternatif) par l'utilisation astucieuse d'une partie linéaire de l'évolution de la tension générée par le convertisseur en fonction du champ.

En outre, le présent détecteur de courant fonctionne sans aimants permanents.

Suivant des modes de réalisation particuliers, le détecteur de courant comprend une ou plusieurs des caractéristiques suivantes, prise(s) isolément ou suivant toutes les combinaisons techniquement possibles :
- le circuit de détection comporte, en outre, un filtre passe-bas positionné après l'unité de démodulation.
- le détecteur comporte un concentrateur de flux magnétique présentant un entrefer, la sonde étant positionnée dans l'entrefer du concentrateur.
- le concentrateur comporte deux parties.
- le détecteur comporte un support présentant deux extrémités, une première extrémité de maintien de la sonde et une deuxième extrémité fixée au conducteur.
- le détecteur comporte le conducteur dans lequel le courant à mesurer circule, le conducteur délimitant une boucle pour laquelle un centre est défini, la sonde étant positionnée au centre de la boucle.

La description concerne aussi un système, notamment un moteur, comprenant un détecteur tel que précédemment décrit.

La description porte également sur un capteur de champ magnétique défini par la revendication 8.

La description concerne aussi un procédé de mesure d'un courant défini par la revendication 9.

D'autres caractéristiques et avantages de l'invention apparaîtront à la lecture de la description qui suit, de modes de réalisation de l'invention, donnée à titre d'exemple uniquement et en référence aux dessins qui sont :
- figure 1, une représentation schématique d'un exemple de détecteur de courant comprenant un convertisseur de champ magnétique en tension ;
- figure 2, un graphe montrant l'évolution de la tension générée par le convertisseur de la figure 1 en fonction du champ et trois encarts présentant l'évolution temporelle de la tension générée pour trois points spécifiques de fonctionnement notées respectivement A, B et C ;
- figure 3, une représentation schématique partielle d'un autre exemple de détecteur de courant vu de côté ;
- figure 4, une représentation schématique partielle d'encore un autre exemple de détecteur de courant vu de côté ;
- figure 5, une représentation schématique partielle d'un autre exemple de détecteur de courant vu de côté, et
- figure 6, une représentation schématique d'une variante du détecteur de courant de la figure 5.

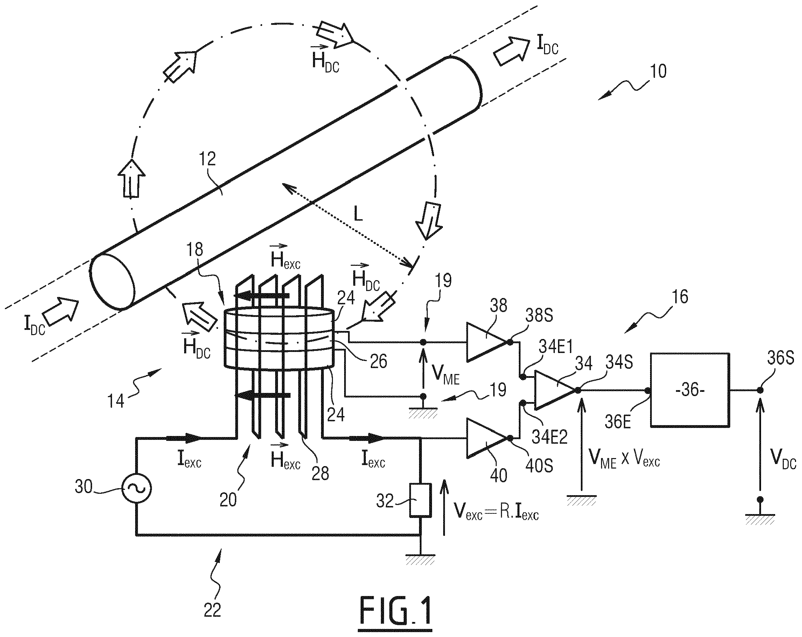

Un détecteur de courant 10 est représenté sur la figure 1.

Le détecteur 10 est propre à mesurer un courant circulant dans un conducteur électrique 12.

Le détecteur 10 est un détecteur sans contact.

Il est entendu par « mesurer » de mesurer l'amplitude instantanée du courant à mesurer.

Le détecteur 10 de la figure 1 est propre à mesurer à la fois l'amplitude du courant à mesurer et le signe du courant à mesurer.

Le détecteur 10 est ainsi propre à mesurer des courants continus et des courants alternatifs simultanément.

Toutefois, de manière plus générale, le détecteur 10 est propre à mesurer seulement l'un des deux types de courant, à savoir soit un courant continu soit un courant alternatif.

De plus, comme visible sur la figure 1, le conducteur 12 est un câble électrique.

Lorsqu'un courant électrique traverse le conducteur 12, le conducteur 12 est propre à générer un champ magnétique induit noté H_{DC}.

Le champ magnétique induit H_{DC} produit des lignes de champ formant des cercles concentriques. Pour illustrer sur la figure 1 le cercle formé par les lignes de champ à une distance L autour du conducteur 12, plusieurs vecteurs sont représentés par une flèche blanche.

Le détecteur de courant 10 comporte une sonde 14 et un circuit de détection 16.

La sonde 14 comporte un convertisseur 18, un enroulement d'excitation 20 et un circuit d'alimentation 22.

Le convertisseur 18 est placé à la distance L du conducteur 12. La distance entre le convertisseur 18 et le conducteur 12 est mesurée entre leur deux centres de gravités.

Le convertisseur 18 est propre à convertir le champ magnétique induit par le courant à mesurer dans le conducteur 12 en une tension entre les bornes 19 du convertisseur 18.

Dans l'exemple proposé, le convertisseur 18 est un matériau composite magnétostrictif et piézoélectrique.

Un tel composite est parfois aussi dénommé sous l'appellation composite magnétoélectrique.

Dans la représentation de la figure 1, le convertisseur 18 comporte deux premières couches 24 en matériau magnétostrictif et une deuxième couche 26 en matériau piézoélectrique.

La première couche 24 et la deuxième couche 26 sont couplées mécaniquement.

Le matériau magnétostrictif est une ferrite de nickel-zinc-cobalt dont la composition est Ni_{1-x-y}ZnₓCo_{y}Fe₂O₄ où les valeurs x et y sont telles que 0<x<0,5 et 0<y<0,1.

En variante, le matériau magnétostrictif est un alliage de fer, terbium et de dysprosium.

Selon une autre variante, le matériau magnétostrictif est en cobalt ou en nickel ou en fer ou en alliage d'au moins deux des trois métaux précités.

Selon encore une autre variante, le matériau magnétostrictif est un alliage de fer et de gallium.

Selon encore une autre variante, le matériau magnétostrictif est un alliage de fer et d'aluminium.

Selon encore une autre variante, le matériau magnétostrictif est en alliage métallique amorphe magnétique.

Par exemple, le matériau piézoélectrique 26 est réalisé en PZT (Titano-Zirconate de Plomb) ou en PVDF (poly(fluorure de vinylidène) plus communément désigné sous son appellation anglaise de « PolyVinyliDene Fluoride »).

Toutefois, tout matériau piézoélectrique est envisageable pour former la deuxième couche 26.

Les deux premières couches 24 et la deuxième couche 26 sont superposées selon une direction d'empilement.

Les couches 24 et 26 sont collées entre elles ou coffritées, ou les couches 24 sont déposées sur la couche 26 par une méthode d'électrodéposition de métaux

La deuxième couche 26 est intercalée entre les deux premières couches 24.

Les rapports d'aspect des couches 24 et 26 sont compris entre 1 et 10000.

Par définition, le rapport d'aspect d'une couche est le rapport entre le diamètre de la couche et l'épaisseur de la couche. Comme visible sur le schéma, les couches présentent une forme de cylindre à base circulaire, le diamètre étant le diamètre de la base et l'épaisseur étant la hauteur du cylindre.

En variante, les couches 24 et 26 ont une section carrée, ou rectangulaire, ou une section d'une forme quelconque.

En variante, les couches 24 et 26 ont des sections et des dimensions différentes.

En variante, le convertisseur 18 comporte plus de premières ou deuxièmes couches 24 et 26.

En pratique, le nombre de couche optimal dépend du choix des matériaux utilisés pour former la première couche 24 et la deuxième couche 26.

En variante, le matériau magnétoélectrique est obtenu par cofrittage d'un mélange de poudres de matériaux piézoélectriques et de poudres de matériaux magnétostrictifs.

En présence d'un champ magnétique variable, le matériau magnétostrictif de chaque première couche 24 se déforme.

La déformation du matériau magnétostrictif est transmise au matériau piézoélectrique puisque chaque première couche 24 est couplée mécaniquement avec la deuxième couche 26.

La déformation transmise au matériau piézoélectrique génère une différence de potentiel entre les bornes du convertisseur 18.

Une telle transformation d'un champ magnétique variable en tension est appelé effet magnétoélectrique direct.

La tension obtenue est appelée tension magnétoélectrique et est notée dans la suite V_{ME}.

L'enroulement d'excitation 20 comporte des spires 28 formant ainsi une bobine.

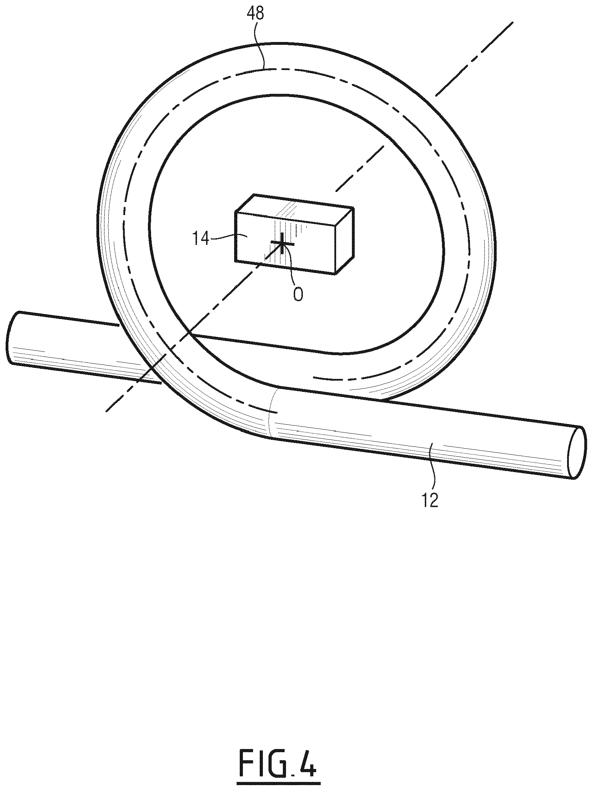

Dans la figure 1, 4 spires 28 sont représentées.

Plus généralement, le nombre de spires 28 est compris entre 10 et 1000.

L'enroulement d'excitation 20 est agencé pour exciter le convertisseur 18.

Plus précisément, l'enroulement d'excitation 20 est agencé pour générer un champ magnétique de modulation noté H_{exc} dans le convertisseur 18.

Le champ magnétique de modulation est représenté sur la figure 1 par des flèches noires.

En l'espèce, les spires 28 sont enroulées autour de la direction suivie par le champ magnétique induit Hoc.

Le circuit d'alimentation 22 est propre à alimenter l'enroulement d'excitation 20.

Le circuit d'alimentation 22 comporte une source d'excitation 30 et une résistance 32.

La source d'excitation 30, la résistance 32 et l'enroulement d'excitation 20 sont branchés en série.

La source d'excitation 30 est propre à générer un courant d'excitation I_{exc}.

Le courant d'excitation I_{exc} généré par la source d'excitation 30 est un courant alternatif, de forme sinusoïdale, ou triangulaire ou carrée, ou d'une forme quelconque.

En outre, le courant d'excitation I_{exc} présente une fréquence, dite fréquence d'excitation, supérieure ou égale à 100 Hertz.

Avantageusement, la fréquence d'excitation est supérieure ou égale à 100 kiloHertz (kHz).

La source d'excitation 30 est aussi propre à générer un courant alternatif d'amplitude constante.

L'amplitude du courant d'excitation I_{exc} est comprise entre 1 milliampères (mA) et 200 mA.

La résistance 32 permet de convertir le courant d'excitation I_{exc} en une tension d'excitation V_{exc}.

La source d'excitation 30 et l'enroulement d'excitation 20 forment ainsi un circuit d'excitation propre à imposer un champ magnétique d'excitation dans le convertisseur 18.

Le circuit de détection 16 est un circuit électronique propre à détecter la tension convertie V_{ME} par le convertisseur 18.

Plus précisément, le circuit de détection 16 met en oeuvre une détection synchrone de la tension convertie V_{ME}.

Selon l'exemple proposé, le circuit de détection 16 comporte un premier amplificateur 38, un deuxième amplificateur 40, une unité de démodulation 34 et un filtre 36.

Dans l'exemple proposé, l'unité de démodulation 34 est un multiplieur propre à multiplier deux signaux d'entrée, l'un étant envoyé sur une première entrée 34E1 et l'autre sur une deuxième entrée 34E2.

Le premier amplificateur 38 est propre à amplifier le signal converti V_{ME} selon un premier gain, la sortie 38S du premier amplificateur 38 étant reliée à la première entrée 34E1 de l'unité de démodulation 34.

Le deuxième amplificateur 40 est propre à amplifier la tension d'excitation V_{exc} selon un deuxième gain, la sortie 40S du deuxième amplificateur 40 étant reliée à la deuxième entrée 34E2 de l'unité de démodulation 34.

Le filtre 36 est positionné après l'unité de démodulation 34. L'entrée 36E du filtre 36 est reliée à la sortie 34S de l'unité de démodulation 34.

Le filtre 36 est ainsi propre à filtrer le signal issu de l'unité de démodulation 34, à savoir un signal proportionnel au produit du signal converti V_{ME} et de la tension d'excitation V_{exc}.

Dans l'exemple décrit, le filtre 36 est un filtre passe-bas permettant de filtrer la composante à 2 fois la fréquence de la tension d'excitation V_{exc} du signal converti V_{ME} multiplié par la tension d'excitation V_{exc}.

A titre d'illustration, le filtre 36 est un filtre d'ordre 1 ou 2.

Selon une variante, le filtre 36 est réalisé numériquement.

En sortie du filtre 36, il est ainsi obtenu une tension filtrée V_{DC} représentative du champ magnétique induit H_{DC} entre la sortie 36S du filtre 36 et la masse.

Le fonctionnement du détecteur 10 est maintenant illustré en référence à un exemple de mise en oeuvre d'un procédé de mesure d'un courant à mesurer.

Le procédé de mesure comporte une étape de conversion et une étape de détection.

Lors de l'étape de conversion, le convertisseur 18 convertit le champ magnétique induit H_{DC} et le champ magnétique d'excitation H_{exc} en une tension V_{ME}.

Le circuit de détection 16 détecte alors la tension convertie, ce qui permet de déterminer le champ induit H_{DC} et ainsi le courant à mesurer.

Le détecteur 10 permet de détecter avec un circuit électronique simplifié le courant à mesurer.

Pour bien comprendre un tel avantage, il convient de mieux comprendre le fonctionnement du convertisseur 18.

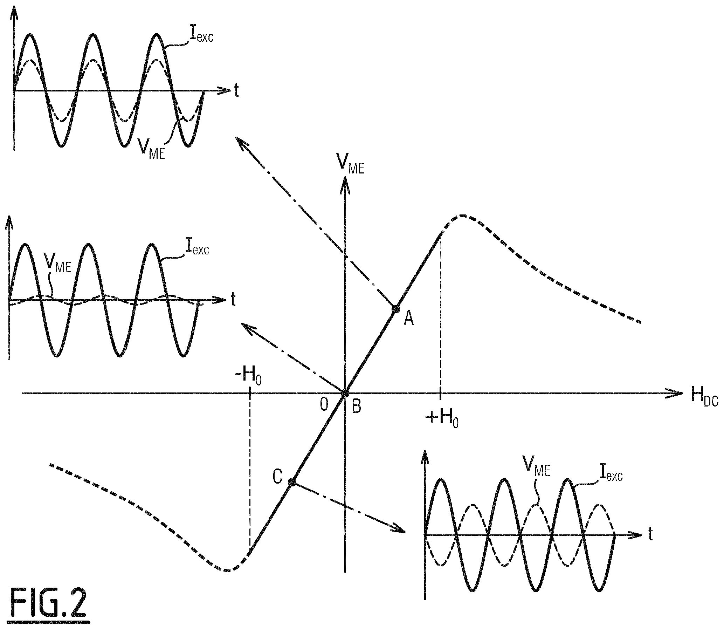

Le convertisseur 18 présente une caractéristique tension électrique - champ magnétique H_{DC} représentée sur la figure 2, pour un courant sinusoïdal d'excitation I_{exc} d'amplitude fixée.

La caractéristique du convertisseur 18 présente une portion linéaire pour un champ magnétique présentant une valeur inférieure en valeur absolue à une valeur seuil notée H₀.

La valeur seuil notée H₀ est obtenue expérimentalement pour toute combinaison de matériaux composant les couches 24 et 26.

Il est à noter que la portion linéaire comporte la valeur correspondant à un champ nul.

Tous les cas de figures possibles sont illustrés par les trois encarts représentés sur la figure 2.

Lorsque le courant à mesurer est positif (encart correspondant au point A sur la figure 2), le champ généré est strictement positif et strictement inférieur à la valeur seuil H₀. Le signal converti V_{ME} et le courant d'excitation I_{exc} sont alors en phase. Le signal sinusoïdal obtenu par la multiplication des deux signaux présente une fréquence double de la fréquence d'excitation et est toujours positif. La moyenne est reliée linéairement à l'amplitude du courant à mesurer.

Lorsque le courant à mesurer est négatif (encart correspondant au point C sur la figure 2), le champ généré est strictement négatif et strictement supérieur à l'opposé de la valeur seuil -H₀. Le signal converti V_{ME} et le courant d'excitation I_{exc} sont alors en opposition de phase, ce qui résulte en une moyenne négative également reliée linéairement à l'amplitude du courant à mesurer.

Au voisinage de 0 (encart correspondant au point B sur la figure 2), le signal sinusoïdal obtenu est une sinusoïde centrée autour de 0.

Ainsi, il est obtenu en sortie du détecteur 10 une tension V_{DC} qui est l'image du courant à mesurer sur une plage de courant compris entre -I_{O} et I_{O} où I_{O} correspond à la valeur de courant induisant un champ de valeur H_{O}.

Du fait de la symétrie de la plage linéaire autour de la valeur de champ nulle du convertisseur 18, le détecteur 10 présente une dynamique plus importante que les autres détecteurs connus à base de matériaux magnétoélectriques.

En outre, le détecteur 10 peut fonctionner sans utiliser un aimant permanent ou tout autre élément permettant de générer une polarisation statique.

Le détecteur 10 présente aussi l'avantage de pouvoir détecter tout type de courant, à savoir des courants continus et alternatifs.

Du fait de l'utilisation de la démodulation synchrone, le détecteur 10 présente une meilleure réjection du bruit, en particulier dans un environnement où le réseau électrique produit de fortes perturbations électromagnétiques à 50 Hertz (Hz).

En outre, le détecteur 10 est propre à détecter le courant quel que soit le sens de propagation du courant dans le conducteur 12. Le détecteur 10 est ainsi un détecteur bidirectionnel.

Le détecteur 10 implique un circuit de détection 16 relativement simple, ce qui facilite la mise en oeuvre du procédé de mesure. En effet, le circuit de détection 16 de la figure 1 comporte uniquement une unité de démodulation 34, un filtre 36 et deux amplificateurs 38 et 40, soit un faible nombre de composants (quatre dans le cas de la figure 1).

Du fait d'une telle simplicité et de la précision de mesure obtenue, le détecteur 10 est ainsi bien approprié pour être utilisé dans des systèmes où le contrôle du courant est souhaitable. C'est notamment le cas pour les moteurs électriques des véhicules automobiles, les moteurs dans les systèmes de traction ferroviaire, les alternateurs d'éoliennes et les alimentations à découpage. Plus généralement, les systèmes de conversion électrique - électrique, électronique ou électromécanique sont des systèmes dans lesquels l'emploi du détecteur 10 est particulièrement indiqué.

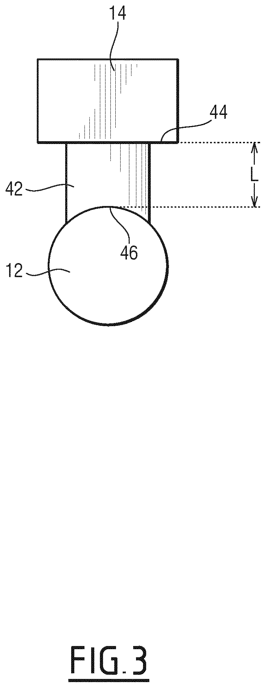

La figure 3 présente un autre exemple de détecteur 10.

Seules les différences entre les détecteurs 10 des figures 1 et 3 sont mises en évidence dans la suite de la description.

Dans le cas de la figure 3, le détecteur 10 comporte un support 42 présentant deux extrémités, une première extrémité 44 de maintien de la sonde 14 et une deuxième extrémité 46 fixée au conducteur 12.

Le support 42 est réalisé en un matériau ni magnétique ni conducteur.

Le support 42 sert notamment à positionner le convertisseur 18 de manière stable par rapport au conducteur 12. En particulier, le support 42 permet que la distance et l'orientation du convertisseur 18 restent fixes par rapport au conducteur 12.

Dans le cas de la figure 1, l'intensité du champ H_{dc} issu du conducteur 12 varie en 1/L. La distance entre la première extrémité 44 et la deuxième extrémité 46 est de L de sorte que le positionnement de la sonde 14 reste bien constant au cours de la mesure pour que l'intensité du champ H_{DC} vue par le détecteur 10 ne dépende que du courant I_{DC}.

Une variante de détecteur 10 est représentée sur la figure 4.

Dans la mesure où l'ensemble des éléments est commun avec le cas du détecteur de la figure 1, seules les différences sont soulignées dans ce qui suit et sont visibles sur la figure 4 dans un souci de clarté.

Dans un tel exemple, le détecteur 10 comporte le conducteur 12 dans lequel le courant à mesurer circule.

En outre, le conducteur 12 présente une spire de sorte que le conducteur 12 délimite une boucle 48 pour laquelle un centre O est défini.

La sonde 14 est positionnée au centre de la boucle 48 délimitée par le conducteur 12.

Cela permet d'augmenter la sensibilité du détecteur 10.

Pour améliorer un tel effet, il est envisageable que le conducteur 12 comporte plusieurs boucles successives.

Dans un tel cas, un support en matériau réalisée dans un matériau ni magnétique ni conducteur est avantageusement utilisé pour fixer rigidement la sonde 14 de sorte que la sonde 14 ne puisse bouger à l'intérieur de la ou des spires pendant la durée de mesure.

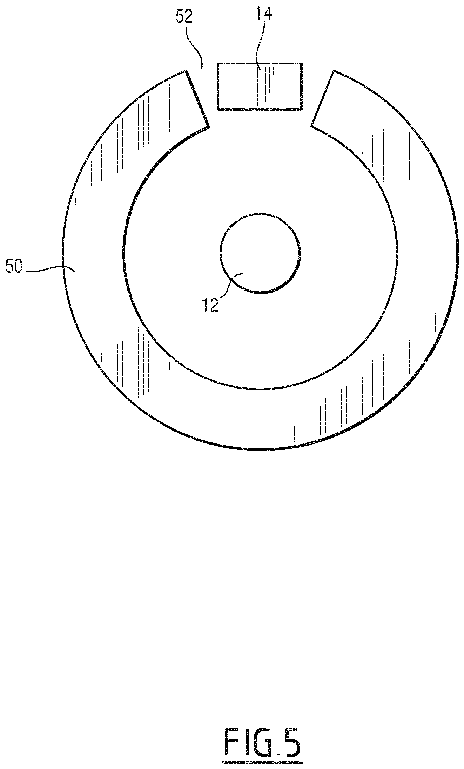

Un autre exemple de détecteur 10 est illustré schématiquement par la figure 5.

Seules les différences entre les détecteurs 10 des figures 1 et 5 sont mises en évidence dans la suite de la description.

Dans l'exemple de la figure 5, le détecteur 10 comporte, en outre, un concentrateur de flux magnétique 50.

Le concentrateur de flux 50 est propre à concentrer et à guider les lignes de champs magnétiques vers un entrefer 52.

Il est également connu de désigner un concentrateur de flux sous l'appellation « canaliseur de flux ».

Selon l'exemple de la figure 5, le concentrateur de flux 50 présente une forme annulaire dans laquelle un entrefer 52 a été réalisé.

Dans chacun des cas, le concentrateur de flux 50 est réalisé en un matériau magnétique doux, tel un ferrite manganèse-zinc, des ferrites nickel-zinc ou un alliage de fer et de silicium.

La sonde 14 est positionnée dans l'entrefer 52 du concentrateur de flux magnétique 50.

Cela permet d'augmenter la sensibilité du détecteur 10 et de rendre la sensibilité du détecteur 10 indépendante de la position du conducteur 12 dans le concentrateur de flux 50.

Selon l'exemple proposé, le concentrateur de flux 50 est réalisé en une seule partie.

Toutefois, en variante, le concentrateur de flux 50 est aussi réalisé en plus de deux parties.

Cela permet de réaliser une sorte de pince ampérométrique d'usage aisé.

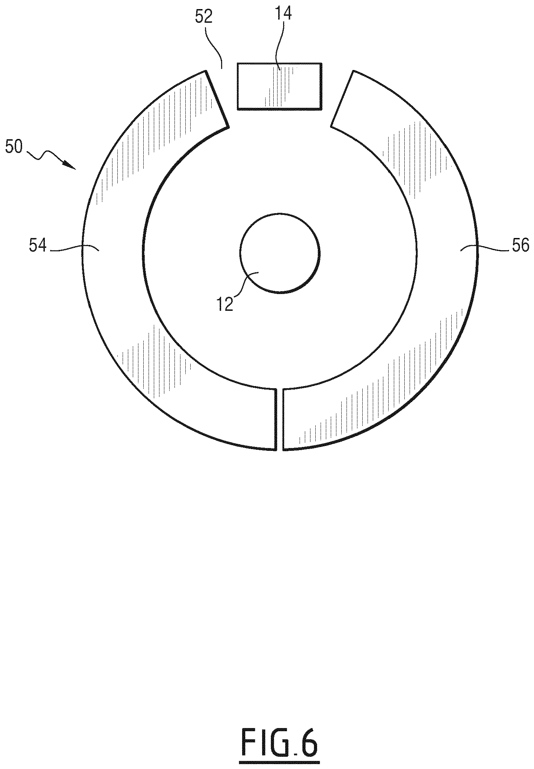

Par exemple, comme visible sur la figure 6, le concentrateur de flux 50 est réalisé en deux parties identiques 54 et 56, ce qui permet de monter le concentrateur de flux 50 sans avoir besoin de démonter le conducteur 12.

D'autres modes de réalisation du détecteur 10 sont envisageables, notamment en ce qui concerne le circuit de détection 16.

Selon un exemple, pour augmenter l'insensibilité aux perturbation extérieures, au moins l'un des amplificateurs 38 et 40 est monté en différentiel.

Le premier amplificateur 38 recueillant le signal issu de la deuxième couche 26 sert à amplifier le signal d'un transducteur essentiellement capacitif.

Selon un premier exemple de réalisation, le premier amplificateur 38 est un amplificateur de très forte impédance d'entrée, c'est-à-dire un amplificateur présentant une impédance d'entrée comprise entre 100 kiloOhms (kOhms) et 100 GigaOhms (GOhms).

Avantageusement, le premier amplificateur 38 comporte un circuit de type bootstrap pour augmenter l'impédance d'entrée.

Selon un deuxième exemple de réalisation, le premier amplificateur 38 est un amplificateur de charge (en différentiel ou non).

Selon encore un autre exemple, pour rendre le détecteur 10 encore plus simple, le nombre de composants du circuit de détection 16 peut encore être diminué en supprimant les deux amplificateurs 38 et 40 et en utilisant comme unité de démodulation 34 un multiplieur d'impédance d'entrée et de gain compatibles avec le reste du montage.

Pour rendre le détecteur 10 encore plus simple, le nombre de composants du circuit de détection 16 peut encore être diminué dans un autre mode de réalisation en utilisant uniquement les deux amplificateurs 38 et 40 suivis de deux convertisseurs analogiques-numériques reliés à un calculateur propre à effectuer les opérations de démodulation et filtrage dans le domaine numérique.

Par exemple, un tel calculateur est un microcontrôleur.

En variante, le calculateur est un circuit logique programmable. Un tel circuit est souvent désigné sous l'acronyme FPGA (acronyme anglais de l'expression « field-programmable gate array » signifiant littéralement « réseau de portes programmables in situ »).

Selon un autre exemple, le calculateur est un circuit intégré propre à une application. Un tel circuit est souvent désigné par l'acronyme ASIC (acronyme de l'anglais « application-specific integrated circuit » signifiant littéralement « circuit intégré propre à une application »).

Plus généralement, le circuit de détection 16 est réalisé au moyen de circuits électroniques soit numériques soit électroniques.

Dans chacun des cas, le circuit de détection 16 joue au moins l'un des rôles suivants : adapter l'impédance, amplifier un signal, multiplier un signal ou filtrer un signal.

En variante ou en complément, le détecteur 10 comporte un système d'amortissement de résonances.

Le système d'amortissement sert à amortir des modes de résonance mécaniques que peut présenter le détecteur 10, typiquement à des fréquences de quelques centaines de kilohertz, qui peuvent être excités lorsque des signaux transitoires apparaissent dans le conducteur 12.

Selon un premier exemple particulier, le système d'amortissement est formé par une ou deux couches supplémentaires de matériau dissipatif collée sur une ou deux des couches 24 de matériau magnétique.

A titre d'exemple spécifique, le matériau dissipatif est un polymère chargé de poudre métallique.

Selon un premier exemple particulier, le système d'amortissement est un circuit électrique formé par un ensemble de composants choisis parmi une résistance, une inductance et un condensateur. L'ensemble est relié aux bornes des contacts de la deuxième couche soit via le premier amplificateur 38 soit directement lorsque celui-ci est absent.

Le système d'amortissement est alors apte à amortir de manière efficace les résonances du détecteur 10 aux fréquences où elles se produisent.

Selon encore un autre mode de réalisation, le signal représentant l'excitation utilisée pour la détection synchrone dans la figure 1 provient d'un moyen permettant d'obtenir un signal représentatif de l'excitation H_{exc} de la mesure du courant autre que la résistance 32 placée en série avec les spires. En particulier, il peut être envisager de placer un capteur adapté à l'endroit nécessaire ou d'utiliser directement le signal fourni par la source d'excitation 30.

Dans tous les modes de réalisations précités et même lorsque ces modes de réalisation sont combinés lorsque cela est techniquement possible, le détecteur de courant 10 est plus simple et permet de mesurer un courant électrique avec une précision de mesure satisfaisante et stable dans le temps.

Un tel principe de détection est également utilisable pour le cas d'un capteur de champ magnétique qui comporte alors uniquement la sonde 14 et le circuit de détection 16, le champ magnétique étant proportionnel à la tension convertie détectée.

## Revendications

1. Détecteur de courant (10) propre à mesurer un courant circulant dans un conducteur électrique (12), le détecteur de courant (10) comportant :
- une sonde (14) comportant :
- un convertisseur (18) propre à convertir le champ magnétique induit par le courant à mesurer dans le conducteur (12) en une tension, le convertisseur (18) étant un matériau composite magnétostrictif et piézoélectrique, et
- un circuit de détection (16) de la tension convertie par le convertisseur (18), la sonde (14) comportant, en outre, un enroulement d'excitation (20) agencé pour générer un champ magnétique de modulation dans le convertisseur (18), le circuit de détection (16) comportant une unité de démodulation (34) de la tension convertie par le convertisseur (18), le détecteur de courant étant **caractérisé par** le convertisseur (18) présentant une caractéristique tension électrique - champ magnétique comportant une portion linéaire, le convertisseur (18) étant propre à convertir le champ magnétique induit par le courant à mesurer dans la portion linéaire de la caractéristique tension électrique - champ magnétique.

2. Détecteur selon la revendication 1, dans lequel le circuit de détection (16) comporte, en outre, un filtre passe-bas (36) positionné après l'unité de démodulation (34).

3. Détecteur selon la revendication 1, dans lequel le détecteur (10) comporte un concentrateur de flux magnétique (50) présentant un entrefer (52), la sonde (14) étant positionnée dans l'entrefer (52) du concentrateur (50).

4. Détecteur selon la revendication 3, dans lequel le concentrateur (50) comporte deux parties (54, 56).

5. Détecteur selon l'une quelconque des revendications 1 à 4, dans lequel le détecteur (10) comporte un support (42) présentant deux extrémités (44, 46), une première extrémité (44) de maintien de la sonde (14) et une deuxième extrémité (46) fixée au conducteur (12).

6. Détecteur selon l'une quelconque des revendications 1 à 4, dans lequel le détecteur (10) comporte le conducteur (12) dans lequel le courant à mesurer circule, le conducteur (12) délimitant une boucle pour laquelle un centre est défini, la sonde (14) étant positionnée au centre de la boucle (48).

7. Système, notamment un moteur, comprenant un détecteur (10) selon l'une quelconque des revendications 1 à 6.

8. Capteur de champ magnétique propre à mesurer un champ magnétique, le capteur de champ comportant :
- une sonde (14) comportant :
- un convertisseur (18) propre à convertir le champ magnétique induit par un conducteur (12) en une tension, le convertisseur (18) étant un matériau composite magnétostrictif et piézoélectrique, et
- un circuit de détection (16) de la tension convertie par le convertisseur (18), la sonde (14) comportant, en outre, un enroulement d'excitation (20) agencé pour générer un champ magnétique de modulation dans le convertisseur (18), le circuit de détection (16) comportant une unité de démodulation (34) de la tension convertie par le convertisseur (18), le capteur de champ magnétique étant **caractérisé par** le convertisseur (18) présentant une caractéristique tension électrique - champ magnétique comportant une portion linéaire, le convertisseur (18) étant propre à convertir le champ magnétique induit par un courant à mesurer dans la portion linéaire de la caractéristique tension électrique - champ magnétique.

9. Procédé de mesure d'un courant circulant dans un conducteur électrique (12) par un détecteur de courant (10) comportant un convertisseur (18) et un circuit de détection (16), le détecteur de courant comportant un enroulement d'excitation (20) agencé pour générer un champ magnétique de modulation dans le convertisseur (18), le circuit de détection (16) comportant une unité de démodulation (34) de la tension convertie par le convertisseur (18), le convertisseur (18) étant un matériau composite magnétostrictif et piézoélectrique, le convertisseur (18) présentant une caractéristique tension électrique - champ magnétique comportant une portion linéaire, le procédé comportant :
- la conversion par le convertisseur (18) du champ magnétique induit par le courant à mesurer dans le conducteur (12) en une tension, la conversion étant réalisée dans la portion linéaire de la caractéristique tension électrique - champ magnétique, et
- la détection par le circuit de détection (16) de la tension convertie par le convertisseur (18).

## Patentansprüche

1. Stromdetektor (10), der geeignet ist, einen Strom zu messen, der in einem elektrischen Leiter (12) fließt, wobei der Stromdetektor (10) beinhaltet:
- eine Sonde (14), beinhaltend:
- einen Wandler (18), der geeignet ist, das durch den zu messenden Strom im Leiter (12) induzierte Magnetfeld in eine Spannung umzuwandeln, wobei der Wandler (18) ein magnetostriktiver und piezoelektrischer Verbundwerkstoff ist, und
- eine Schaltung der Detektion (16) der Spannung, die vom Wandler (18) umgewandelt wurde, wobei die Sonde (14) ferner eine Erregerwicklung (20) beinhaltend, die angeordnet ist, um ein Modulationsmagnetfeld im Wandler (18) zu erzeugen, wobei die Detektionsschaltung (16) eine Einheit der Demodulation (34) der vom Wandler (18) umgewandelten Spannung beinhaltet, wobei der Stromdetektor **dadurch gekennzeichnet ist, dass** der Wandler (18) eine elektrische Spannungs-Magnetfeld-Charakteristik aufweist, die einen linearen Teil beinhaltet, wobei der Wandler (18) geeignet ist, das durch den zu messenden Strom induzierte Magnetfeld in den linearen Teil der elektrischen Spannungs-Magnetfeld-Charakteristik umzuwandeln.

2. Detektor nach Anspruch 1, wobei die Detektionsschaltung (16) ferner einen Tiefpassfilter (36) beinhaltet, der nach der Demodulationseinheit (34) positioniert ist.

3. Detektor nach Anspruch 1, wobei der Detektor (10) einen Magnetflusskonzentrator (50) beinhaltet, der einen Luftspalt (52) aufweist, wobei die Sonde (14) im Luftspalt (52) des Konzentrators (50) positioniert ist.

4. Detektor nach Anspruch 3, wobei der Konzentrator (50) zwei Bereiche (54, 56) beinhaltet.

5. Detektor nach einem der Ansprüche 1 bis 4, wobei der Detektor (10) einen Träger (42) beinhaltet, der zwei Enden (44, 46) aufweist, ein ersten Ende (44) zum Halten der Sonde (14) und ein zweites Ende (46), das am Leiter (12) befestigt ist.

6. Detektor nach einem der Ansprüche 1 bis 4, wobei der Detektor (10) den Leiter (12) beinhaltet, durch den der zu messende Strom fließt, wobei der Leiter (12) eine Schleife begrenzt, für die ein Zentrum definiert ist, wobei die Sonde (14) im Zentrum der Schleife (48) positioniert ist.

7. System, insbesondere ein Motor, einen Detektor (10) nach einem der Ansprüche 1 bis 6 umfassend.

8. Magnetfeldsensor, der geeignet ist, ein Magnetfeld zu messen, wobei der Feldsensor beinhaltet:
- eine Sonde (14), beinhaltend:
- einen Wandler (18), der geeignet ist, das durch einen Leiter (12) induzierte Magnetfeld in eine Spannung umzuwandeln, wobei der Wandler (18) ein magnetostriktiver und piezoelektrischer Verbundwerkstoff ist, und
- eine Schaltung der Detektion (16) der Spannung, die vom Wandler (18) umgewandelt wurde, wobei die Sonde (14) ferner eine Erregerwicklung (20) beinhaltet, die angeordnet ist, um ein Modulationsmagnetfeld im Wandler (18) zu erzeugen, wobei die Detektionsschaltung (16) eine Einheit der Demodulation (34) der vom Wandler (18) umgewandelten Spannung beinhaltet, wobei der Magnetfeldsensor **dadurch gekennzeichnet ist, dass** der Wandler (18) eine elektrische Spannungs-Magnetfeld-Charakteristik aufweist, die einen linearen Teil beinhaltet, wobei der Wandler (18) geeignet ist, das durch einen zu messenden Strom induzierte Magnetfeld in den linearen Teil der elektrischen Spannungs-Magnetfeld-Charakteristik umzuwandeln.

9. Verfahren zum Messen eines Stroms, der in einem elektrischen Leiter (12) fließt, durch einen Stromdetektor (10), der einen Wandler (18) und eine Detektionsschaltung (16) beinhaltet, wobei der Stromdetektor eine Erregerwicklung (20) beinhaltet, die angeordnet ist, um ein Modulationsmagnetfeld im Wandler (18) zu erzeugen, wobei die Detektionsschaltung (16) eine Einheit der Demodulation (34) der vom Wandler (18) umgewandelten Spannung beinhaltet, wobei der Wandler (18) ein magnetostriktiver und piezoelektrischer Verbundwerkstoff ist, wobei der Wandler (18) eine elektrische Spannungs-Magnetfeld-Charakteristik aufweist, die einen linearen Teil beinhaltet, wobei das Verfahren beinhaltet:
- die Umwandlung des durch den zu messenden Strom im Leiter (12) induzierten Magnetfelds durch den Wandler (18) in eine Spannung, wobei die Umwandlung im linearen Teil der elektrischen Spannungs-Magnetfeld-Charakteristik erfolgt, und
- die Detektion der Spannung, die vom Wandler (18) umgewandelt wurde, durch die Detektionsschaltung (16).

## Claims

1. A current detector (10) capable of measuring a current circulating in an electrical conductor (12), the current detector (10) including:
- a probe (14) including:
- a converter (18) capable of converting the magnetic field induced by the current to be measured in the conductor (12) into a voltage, the converter (18) being a magnetostrictive and piezoelectric composite material, and
- a circuit (16) for detecting the voltage converted by the converter (18), the probe (14) further including an excitation winding (20) arranged to generate a modulating magnetic field in the converter (18), the detection circuit (16) including a unit (34) for demodulating the voltage converted by the converter (18), the current detector being **characterised by** the converter (18) having an electric voltage-magnetic field feature including a linear portion, the converter (18) being capable of converting the magnetic field induced by the current to be measured in the linear portion of the electric voltage-magnetic field feature.

2. The detector according to claim 1, wherein the detection circuit (16) further includes a low-pass filter (36) positioned after the demodulation unit (34).

3. The detector according to claim 1, wherein the detector (10) includes a magnetic flux concentrator (50) having an air gap (52), the probe (14) being positioned in the air gap (52) of the concentrator (50).

4. The detector according to claim 3, wherein the concentrator (50) includes two parts (54, 56).

5. The detector according to any one of claims 1 to 4, wherein the detector (10) includes a support (42) having two ends (44, 46), a first end (44) for holding the probe (14) and a second end (46) fixed to the conductor (12).

6. The detector according to any one of claims 1 to 4, wherein the detector (10) includes the conductor (12) wherein the current to be measured circulates, the conductor (12) delimiting a loop for which a centre is defined, the probe (14) being positioned in the centre of the loop (48).

7. A system, in particular a motor, comprising a detector (10) according to any one of claims 1 to 6.

8. A magnetic field sensor capable of measuring a magnetic field, the field sensor including:
- a probe (14) including:
- a converter (18) capable of converting the magnetic field induced by a conductor (12) into a voltage, the converter (18) being a magnetostrictive and piezoelectric composite material, and
- a circuit (16) for detecting the voltage converted by the converter (18), the probe (14) further including an excitation winding (20) arranged to generate a modulating magnetic field in the converter (18), the detection circuit (16) including a unit (34) for demodulating the voltage converted by the converter (18), the magnetic field sensor being **characterised by** the converter (18) having an electric voltage-magnetic field feature including a linear portion, the converter (18) being capable of converting the magnetic field induced by a current to be measured in the linear portion of the electric voltage-magnetic field feature.

9. A method for measuring a current flowing in an electrical conductor (12) by a current detector (10) including a converter (18) and a detection circuit (16), the current detector including an excitation winding (20) arranged to generate a modulating magnetic field in the converter (18), the detection circuit (16) including a unit (34) for demodulating the voltage converted by the converter (18), the converter (18) being a magnetostrictive and piezoelectric composite material, the converter (18) having an electric voltage-magnetic field feature including a linear portion, the method including:
- the converter (18) converting the magnetic field induced by the current to be measured in the conductor (12) into a voltage, the conversion being carried out in the linear portion of the electric voltage-magnetic field feature, and
- the detection circuit (16) detecting the voltage converted by the converter (18).
